# EUROPEAN PATENT APPLICATION

(11) **EP 0 872 880 A2**
(43) Date of publication of application: **21.10.1998**
(21) Application number: 97309558.1
(22) Date of filing: 27.11.1997
(51) Int. Cl.: H01L 21/3205, H01L 21/768

(54) **Method for forming a platinum group metal layer for a capacitor**

(30) Priority: 17.04.1997 KR 9714195
(71) Applicant: Samsung Electronics Co., Ltd., Suwon City, Kyungki-do (KR)
(72) Inventor: Park, Young-soh, Seongnam-city, Kyungki-do (KR); Lee, Sang-in, Paldal-gu, Suwon-city, Kyungki-do (KR); Hwang, Cheol-seong, Bungdang-gu, Seongnam-city, Kyungki-do (KR); Hwang, Doo-sup, Bundang-gu, Seongnam-city, Kyungki-do (KR); Cho, Hag-Ju, Seocho-gu, Seoul (KR)
(74) Representative: Robinson, Ian Michael

(57) **Abstract**

A method for forming a platinum group metal layer (65) and a method for manufacturing a storage electrode (82) such as for a capacitor using the same in which contact failure of the storage electrode caused by oxygen diffusion is prevented and the storage electrode can be easily formed. The metal layer (65) of the platinum group is formed on a semiconductor substrate (50, 55) where the opening such as a storage contact hole (54) is formed, in a thickness of approximately 1000Å. The metal layer (65) is reflowed by heating at 650°C or more to fill the opening (54).

## Description

The present invention relates to a method for fabricating a semiconductor device, and more particularly, to a method for forming a metal layer from a platinum group metal and a method for fabricating a capacitor utilizing the same.

In general, large scale integration of a memory device is limited because a reduction in memory cell area causes a reduction in cell capacitance, and it becomes difficult to achieve a desired cell capacitance from a typical dielectric material such as a nitride/oxide (NO) and tantalum pentoxide Ta₂O₅.

Therefore, research has been conducted on a method for forming a dielectric layer of a capacitor using a high performance dielectric material such as Ba(Sr,Ti)O₃ (BST) or Pb(Zr,Ti)O₃ (PZT), having dielectric constant of about one hundred times that of the conventional NO. At this time, it is well known that a metal of the platinum group or an oxide thereof having an excellent oxidation resistance and a relatively low inter-diffusibility with the BST or PZT thin film is suitable for the dielectric material.

When a capacitor electrode is formed from the metal of a platinum group or an oxide thereof, both of which are hereinafter called a 'platinum group metal', a barrier layer is necessary for preventing a reaction of the platinum group metal with polysilicon used for a conductive plug or with a substrate silicon, and for preventing diffusion of oxygen used as a source during deposition of a dielectric layer.

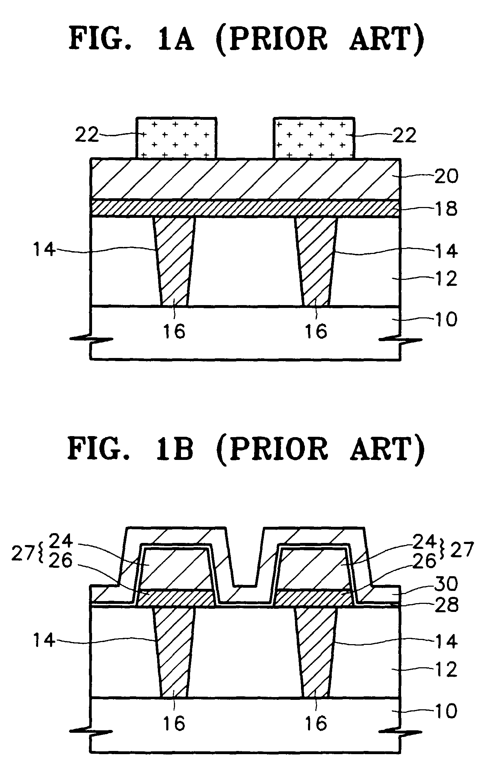

Figures 1A and 1B are sectional views illustrating a conventional method for forming a capacitor storage electrode using platinum.

Referring to Figure 1A, an insulating layer 12 formed on a semiconductor substrate 10 is partially etched to form a storage contact hole 14, and then polysilicon is deposited and etched back to form a conductive plug 16 for filling the storage contact hole 14. A titanium nitride layer 18 as a barrier layer is formed on the resultant structure where the conductive plug 16 is formed, and platinum is deposited on the titanium nitride layer 18 to form a platinum layer 20. Sequentially, an oxide layer to be used as an etching mask is formed on the resultant structure where the platinum layer 20 is formed, and patterned to form a mask pattern 22.

Referring to Figure 1B, using the mask pattern 22 as an etching mask, the platinum layer 20 and the titanium nitride layer 18 are sequentially etched to form a platinum layer pattern 24 and a barrier layer pattern 26. After removing the mask pattern 22, a dielectric layer 28 formed of BST or PZT is deposited on a substrate where the conductive plug 16 and a storage electrode 27 including the barrier layer pattern 26 and the platinum layer pattern 24 is formed, through a sputtering method or a metal organic chemical vapor deposition(MOCVD) method. Then, a plate electrode 30 is formed on the resultant structure.

However, when forming the capacitor using the high dielectric material such as BST or PZT as described above, capacitance increases along with causing problems due to the platinum group metal used as the electrode material and to the titanium nitride layer used as the barrier layer as follows.

First, during formation of the dielectric layer 28, diffusion of oxygen through the side surfaces of the exposed barrier layer 26 deteriorates electrical characteristics of a semiconductor device.

When the dielectric layer 28 is formed in a state where the side surfaces of the barrier layer pattern 26 are exposed, after forming the platinum layer pattern 24, oxygen is easily diffused from the side surfaces of the barrier layer pattern 26. In particular, the oxygen atmosphere and the high temperature in which the high dielectric layer 28 such as BST or PZT is formed accelerate the oxygen diffusion. Due to the oxygen diffusion, the barrier layer pattern 26 is partially oxidized, and a titanium oxide layer TiO₂ (not shown) which has an insulating characteristic is formed on an interface between the conductive plug 16 and the barrier layer pattern 26, or between the barrier layer pattern 26 and the platinum layer pattern 24.

The titanium oxide layer causes contact failure, and deteriorates the function of the barrier layer 26 by allowing diffusion of oxygen or metal atoms therethrough, to generate leakage current between the storage electrode 27 and the semiconductor substrate 10.

Second, since the storage electrode, in particular the platinum layer pattern 24, is required to be thickly formed, it impedes patterning and generates a high step difference around the capacitor.

If the platinum layer pattern 24 of the storage electrode is thin, oxygen passes through the platinum layer pattern 24 to combine with the barrier layer pattern 26. Accordingly, the platinum layer pattern 24 is 2000Å thick or more.

However, since the platinum is very hard and refractory, it cannot easily react with a different chemical material and cannot be easily etched through dry etching such as reactive ion etching. Accordingly, when the platinum layer pattern is 2000Å thick or more, the patterning becomes very difficult, while the platinum layer pattern has great step difference around the capacitor.

Third, it is difficult to secure a mask having a high etching selectivity with respect to the platinum.

In general, the etching mask requires an etch rate lower than that of the material layer to be etched. However, as described above, the platinum group metal has difficulties in etching. Therefore, it is very difficult to obtain an etching mask having an etch rate lower than that of the platinum group metal.

It is an aim of the preferred embodiment of the present invention to provide a method for manufacturing a capacitor capable of preventing contact failure of a storage electrode caused by oxygen diffusion.

It is another aim to provide a method for manufacturing a capacitor capable of easily forming a storage electrode.

It is still another aim to provide a method for forming a platinum group metal layer.

According to a first aspect of the present invention there is provided a method for forming a platinum group metal layer comprising the steps of:
a) forming a material layer on a semiconductor substrate;
b) etching a predetermined portion of the material layer to form an opening;
   characterised by:
c) depositing a platinum group metal on the entire surface of the substrate where the opening is formed; and
d) reflowing the platinum group metal to fill the opening.

Preferably, the material layer is formed of an undoped silicate glass.

Preferably, the platinum group metal is one selected from the group consisting of Pt, Ru, Ir, Rh, Os, RuO₂, and IrO₂.

Preferably, the platinum group metal is formed having a thickness in the region of 1000 to 2000Å.

Preferably, the reflowing is performed in an N₂ atmosphere, in the region of 650 to 900°C, and for in the region of 5 minutes to 1 hour.

According to a second aspect of the present invention there is provided a method for manufacturing a capacitor comprising the steps of:
a) forming an interlayer dielectric on a semiconductor substrate;
b) patterning the interlayer dielectric to form a storage contact hole for exposing a predetermined portion of the substrate;
c) depositing a barrier metal on the entire surface of the substrate where a storage contact hole is formed to form a barrier layer on the interlayer dielectric and the storage contact hole surface;
d) depositing a platinum group metal on the barrier layer to form a metal layer;
e) reflowing the metal layer to form a reflowed metal layer having a predetermined thickness for filling the storage contact hole, on the interlayer dielectric;
f) patterning the reflowed metal layer and the barrier layer to form a storage electrode pattern including a metal layer pattern and a barrier layer pattern;
g) forming a dielectric layer on the metal layer pattern; and
h) forming a plate electrode on the dielectric layer.

Preferably, the method contains the step of:
forming a metal silicide layer for reducing contact resistance with the substrate on the bottom surface of the storage contact hole before said step c).

Preferably, the method contains the step of:
forming an oxygen diffusion barrier layer formed of one selected from the group consisting of Ir, Ru, RuO₂ and IrO₂, between the barrier layer and the metal layer, before said step d).

Preferably, the method contains the step of:
forming a conductive plug for filling a portion of the storage contact hole, before said step c) of forming the barrier layer.

Preferably, said step of forming the conductive plug comprises the sub-steps of:
forming a conductive layer having a predetermined thickness for filling the storage contact hole, on the interlayer dielectric;
removing the conductive layer on the interlayer dielectric by etching back; and
removing a portion of the conductive layer filling the storage contact hole by overetching.

Preferably, said step of forming the conductive plug comprises the sub-steps of:
forming a conductive layer having a predetermined thickness on the interlayer dielectric, to fill the storage contact hole;
removing the conductive layer on the interlayer dielectric using chemical-mechanical polishing; and
removing a portion of the conductive layer in the storage contact hole using the chemical-mechanical polishing in which an etching selectivity between the conductive layer and the interlayer dielectric is controlled.

Preferably, the barrier layer formed on the interlayer dielectric is removed to form the barrier layer only in the storage contact hole, and wherein only the metal layer is patterned during the step of forming the storage electrode pattern.

Preferably, the barrier layer is formed of one selected from the group consisting of TiN, CoSi, TaSiN, TiSiN, TaSi, TiSi, Ta and TaN.

According to a third aspect of the present invention there is provided a method for manufacturing a capacitor comprising the steps of:
a) forming an interlayer dielectric on a semiconductor substrate;
b) patterning the interlayer dielectric to form a storage contact hole for exposing a predetermined portion of the substrate;
c) forming a conductive plug for filling the storage contact hole and overetching the conductive plug to form an opening at the upper end of the storage contact hole in a predetermined thickness;
d) filling the opening at the upper end of the etched storage contact hole to form a barrier layer pattern having unexposable sides;
e) forming an etch stopper having an opening portion where the storage electrode is to be formed, on the interlayer dielectric;
f) depositing a platinum group metal to form a metal layer on the entire surface of the substrate where the etch stopper is formed;
g) reflowing the metal layer to form a reflowed metal layer having a predetermined thickness for filling the opening portion opened by the etch stopper, on the etch stopper;
h) removing the reflowed metal layer until the etch stopper is exposed, to form a metal layer pattern;
i) forming a dielectric layer on the metal layer pattern; and
j) forming a plate electrode on the dielectric layer.

Preferably, the metal layer pattern is formed by chemical-mechanical polishing the reflowed metal layer until the etch stopper is exposed.

Preferably, the method further comprises the step of removing the etch stopper, to thereby form the dielectric layer on the upper and the side surfaces of the metal layer pattern, after said step i).

Preferably, the method further comprises the step of:
forming an etching barrier layer on the interlayer dielectric after said step a), and wherein the storage contact hole is formed by sequentially etching the etching barrier layer and the interlayer dielectric.

Preferably, the metal layer is formed by blanket etching back the reflowed metal layer and the etch stopper until the etching barrier layer is exposed.

Preferably, the etch stopper is formed of an oxide and the etching barrier layer is formed of a nitride.

According to a fourth aspect of the present invention there is provided a method for manufacturing a capacitor comprising the steps of:
a) forming an interlayer dielectric on a semiconductor substrate;
b) patterning the interlayer dielectric to form a storage contact hole for exposing a predetermined portion of the substrate;
c) depositing a barrier metal on the entire surface of the substrate where the storage contact hole is formed to form a barrier layer on the interlayer dielectric and on the surface of the storage contact hole;
d) forming an etch stopper having an opening portion where a storage electrode is to be formed, on the barrier layer;
e) depositing a platinum group metal on the entire surface of the substrate where the etch stopper is formed, to form a metal layer;
f) reflowing the metal layer to form a reflowed metal layer having a predetermined thickness for filling the opening portion opened by the etch stopper and the storage contact hole, on the etch stopper;
g) removing the reflowed metal layer until the etch stopper is exposed, to form a metal layer pattern;
h) removing the etch stopper;
i) patterning the barrier layer using the metal layer pattern as an etching mask, to form a barrier layer pattern only under the metal layer pattern;
j) forming a dielectric layer on the metal layer pattern; and
k) forming a plate electrode on the dielectric layer.

Preferably, the metal layer pattern is formed by chemical mechanical polishing the reflowed metal layer until the etch stopper is exposed.

Preferably, the metal layer pattern is formed by etching back the reflowed metal layer and the etch stopper until the barrier layer is exposed.

Preferably, the method comprises the step of:
forming a conductive plug for filling a portion of the storage contact hole, before the barrier layer is formed.

According to a fifth aspect of the present invention there is provided a method for manufacturing a capacitor comprising the steps of:
a) forming an interlayer dielectric on a semiconductor substrate;
b) patterning the interlayer dielectric to form a storage contact hole for exposing a predetermined portion of the substrate;
c) depositing a barrier layer on the entire surface of a substrate where the storage contact hole is formed, to form a barrier layer on the interlayer dielectric and the surface of the storage contact hole;
d) removing the barrier layer formed on the interlayer dielectric, to form a barrier layer pattern only on the surface of the storage contact hole;
e) forming an etch stopper having an opening portion where a storage electrode is to be formed, on the interlayer dielectric;
f) depositing a platinum group metal to form a metal layer on the entire surface of the substrate where the etch stopper is formed;
g) reflowing the metal layer to form a reflowed metal layer having a predetermined thickness for filling an opening portion opened by the etch stopper and filling the storage contact hole, on the etch stopper;
h) removing the reflowed metal layer until the etch stopper is exposed to form a metal layer pattern;
i) forming a dielectric layer on the metal layer pattern; and
j) forming a plate electrode on the dielectric layer.

Preferably, the method further comprises the step of:
forming an etching barrier layer on the interlayer dielectric after said step a), and wherein the storage contact hole is formed by sequentially etching the etching barrier layer and the interlayer dielectric.

Preferably, the method further comprises the step of:
removing the etch stopper after said step h), to form the dielectric layer on the upper and the side surfaces of the metal layer pattern.

Preferably, the metal layer pattern is formed by chemical-mechanical polishing the reflowed metal layer until the etch stopper is exposed.

Preferably, the metal layer pattern is formed by blanket etching back the reflowed metal layer and the etch stopper until the etching barrier layer is exposed.

Preferably, the method further comprises the step of:
forming a conductive plug for filling a portion of the storage contact hole before said step c).

Preferably, the interlayer dielectric is formed of an oxide undoped with impurities.

Preferably, the metal layer is formed of one selected from the group consisting of Pt, Ru, Ir, Rh, Os, RuO₂ and IrO₂.

Preferably, the metal layer is formed of platinum Pt.

Preferably, the dielectric layer is formed of one selected from the group consisting of Ba(Sr,Ti)O₃, Pb(Zr,Ti)O₃, Ta₂O₅, SiO₂, SiN₃, SrTiO₃, PZT, SrBi₂Ta₂O₉, (Pb, La)(Zr, Ti)O₃, and Bi₄Ti₃O₁₂.

Preferably, the metal layer is formed having a thickness in the region of 1000 to 2000Å.

Preferably, the relowing is performed by heating at more than 650°C.

Preferably, the reflowing is performed in an N₂ atmosphere, in the region of 650 to 900°C, and for in the region of 5 minutes to 1 hour.

In the preferred embodiments, a platinum group metal layer is formed on a semiconductor substrate preferably having a material layer of undoped silicate glass where an opening such as a storage contact hole is formed having a thickness of the order of 1000 ∼ 2000Å, and then the platinum group metal layer is reflowed at 650°C or more to fill the opening.

The platinum group metal layer is reflowed to form the storage electrode of the capacitor. That is, a barrier layer and the platinum group metal layer are formed in the storage contact hole formed on a semiconductor substrate, and then the platinum group metal layer is reflowed to fill the storage contact hole. Subsequently, the platinum group metal layer and the barrier layer are patterned, to form a storage electrode including the platinum group metal layer pattern and the barrier layer pattern. Also, before forming the barrier layer, a conductive plug for filling a portion of the storage contact hole may be formed to enhance an aspect ratio of the storage contact hole.

Accordingly, the platinum group metal layer becomes thicker than conventional one as much as a filling depth of the storage contact hole. As a result, during forming the dielectric layer, a diffusion distance that the oxygen infiltrated through the surface of the platinum group metal layer and the side surfaces of the barrier layer contacts with the portion serving as the barrier layer, becomes long. Therefore, oxidation of the barrier layer can be constrained, and the contact failure of the storage electrode can be prevented. Also, the patterning is more easily performed than that of the conventional art, and a step difference from the portion around the capacitor is reduced.

In an alternative embodiment, a conductive plug and a barrier layer for filling the storage contact hole passing through an interlayer dielectric are formed. An etch stopper having an opening portion where the storage electrode is to be formed is formed on the interlayer dielectric, and the platinum group metal layer is formed and reflowed, to fill the opening portion and the storage contact hole. Then, the platinum group metal layer on the interlayer dielectric is removed by chemical-mechanical polishing (CMP) or etchback, and the etch stopper is removed, to form a storage electrode including the platinum group metal layer pattern and the barrier layer pattern.

Since the platinum group metal layer pattern can be formed through CMP or etchback without using an etching mask, a mask having a high etching selectivity with respect to the metal layer of the platinum group is not required.

Further preferred embodiments of the invention combined the above processes. That is, the barrier layer is formed in the storage contact hole formed on the interlayer dielectric and passing through the interlayer dielectric. At this time, as described above, before forming the barrier layer, a conductive plug for filling a portion of the storage contact hole can be formed to enhance the aspect ratio of the storage contact hole. Then, on the barrier layer formed on the interlayer dielectric, an etch stopper having an opening portion where the storage electrode is to be formed is formed, and then the platinum group metal layer is formed and reflowed, to fill the opening portion and the storage contact hole. Subsequently, the platinum group metal layer on the interlayer dielectric is removed through CMP or etchback, and the etch stopper is removed to form a platinum group metal layer pattern, and the barrier layer is patterned using the platinum group metal layer pattern as a mask to form a storage electrode.

Accordingly, the platinum group metal layer becomes thicker as much as a filling depth of the storage contact hole, to thereby prevent the contact failure of the storage electrode, and the platinum group metal layer pattern can be formed without an etching mask.

For a better understanding of the invention, and to show how embodiments of the same may be carried into effect, reference will now be made, by way of example, to the accompanying diagrammatic drawings, in which:
FIGS 1A and 1B are sectional views for illustrating a conventional method for forming a capacitor storage electrode using platinum;
Figures 2A and 2B are sectional views for illustrating a method for forming a platinum group metal layer according to an embodiment of the present invention;
Figures 3A and 3B are scanning electron microscope (SEM) photographs of a platinum group metal layer reflowed at a predetermined temperature;
Figures 4A through 4F are sectional views for illustrating a method for manufacturing a capacitor according to a first embodiment of the present invention;
Figures 5A and 5B are sectional views for illustrating a method for manufacturing a capacitor according to a second embodiment of the present invention;
Figures 6A and 6B are sectional views for illustrating a method for manufacturing a capacitor according to a third embodiment of the present invention;
Figures 7A and 7B are sectional views for illustrating a method for manufacturing a capacitor according to a fourth embodiment of the present invention;
Figures 8A through 8F and Figure 9 are sectional views for illustrating a method for manufacturing a capacitor according to a fifth embodiment of the present invention;
Figures 10A through 10C are sectional views for illustrating a method for manufacturing a capacitor according to a sixth embodiment of the present invention;
Figures 11A through 11E are sectional views for illustrating a method for manufacturing a capacitor according to a seventh embodiment of the present invention;
Figures 12A through 12C are sectional views for illustrating a method for manufacturing a capacitor according to an eighth embodiment of the present invention;
Figures 13A through 13C are sectional views for illustrating a method for manufacturing a capacitor according to a ninth embodiment of the present invention;
Figure 14 is a sectional view for illustrating a method for manufacturing a capacitor according to a tenth embodiment of the present invention;
Figure 15 is a sectional view for illustrating a method for manufacturing a capacitor according to an eleventh embodiment of the present invention;
Figure 16 is a sectional view for illustrating a method for manufacturing a capacitor according to a twelfth embodiment of the present invention;
Figure 17 is a sectional view for illustrating a method for manufacturing a capacitor according to a thirteenth embodiment of the present invention; and
Figure 18 is a sectional view for illustrating a method for manufacturing a capacitor according to a fourteenth embodiment of the present invention.

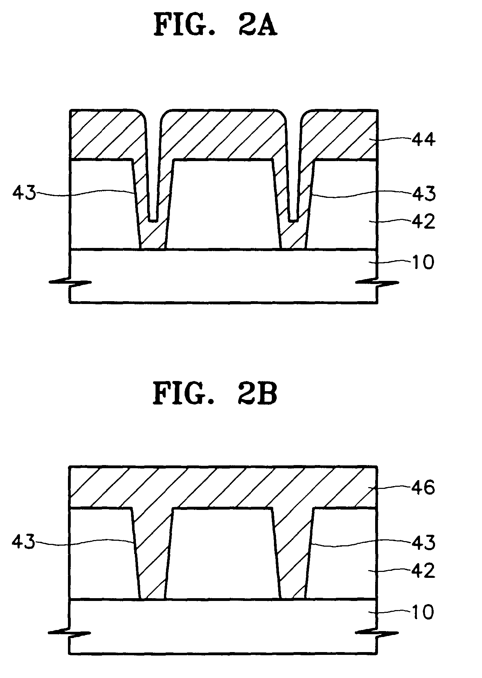

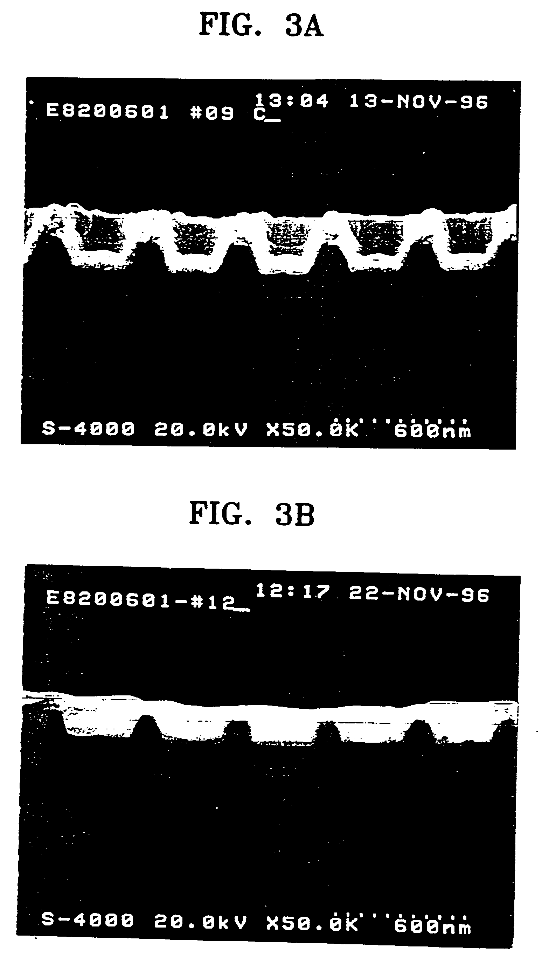

Referring firstly to Figures 2A through 3B, a preferred method for forming a platinum group metal layer will be described.

Figure 2A is a sectional view showing the step of forming a platinum layer 44. Here, an insulating layer 42 is formed on a semiconductor substrate 40, and the insulating layer 42 is partially etched to form an opening 43, and then a metal of the platinum group, for example, platinum, is deposited on the entire surface of the resultant structure where the opening 43 is formed, through a sputtering method to form a platinum layer 44. At this time, the platinum layer 44 is formed in a predetermined thickness, for example, 1000 ∼ 2000Å, and it is possible to use Ru, Ir, Rh, Os, RuO₂ or IrO₂ instead of the platinum.

Figure 2B is a sectional view showing the step of forming a reflowed platinum layer 46. Here, the resultant structure where the platinum layer 44 is formed is introduced into a furnace, for example, a typical quartz tube, and the platinum layer 44 is reflowed, to fill the opening 43 and obtain a platinum layer 46 having a planarized surface.

Here, it is preferable that the platinum layer 44 is reflowed in nitrogen (N2) ambient for around 5 minutes to 1 hour at around 650°C to 900 °C.

Figure 3A is a SEM photograph showing a state in which an undoped silicate glass is deposited on a silicon substrate in a thickness of approximately 4000Å to form an insulating layer, which is patterned to have an insulating layer surface where openings having a predetermined depth are formed, and then a platinum layer is deposited on the entire surface of the resultant structure in a thickness of approximately 1000Å using a sputtering method.

Figure 3B is a SEM photograph showing a result in which the resultant structure where the platinum layer is formed is introduced in the quartz tube, and then thermally treated for approximately 30 minutes in nitrogen ambient at 750°C. Here, the platinum layer is reflowed by thermal treating, to fill the openings formed on the insulating surface and form a planarized platinum layer 46.

The method for forming the platinum group metal layer using the reflow of the platinum group metal can be variously applied. In particular, when a storage electrode of a capacitor is formed by the above method, it is possible to prevent contact failure of the storage electrode due to diffusion of oxygen infiltrated through the side surfaces of the barrier layer and easily form the storage electrode.

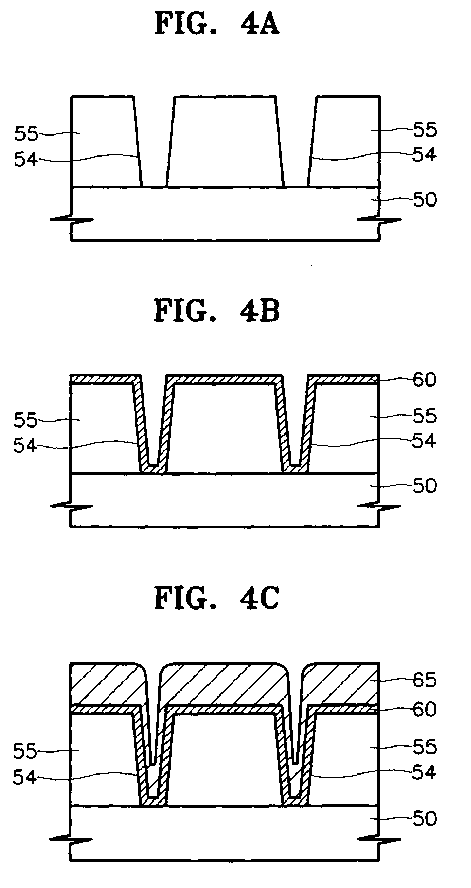

Figure 4A is a sectional view showing a step of forming a storage contact hole 54. Here, an insulating material, for example, an undoped silicate glass (USG), is deposited on a semiconductor substrate 50 to form an interlayer dielectric 55, and then it is patterned to form a contact hole 54 for exposing a predetermined portion of the substrate 50.

Figure 4B is a sectional view showing a step of forming a barrier layer 60. Here, a barrier metal, for example, titanium nitride, is deposited on the entire surface of the substrate where the storage contact hole 54 is formed, through a chemical vapor deposition method, to form a barrier layer 60.

The barrier layer 60, unlike the conventional art of Figure 1, is formed on the entire inside of the storage contact hole 54 as well as on the interlayer dielectric 55. The barrier layer 60 is selected from the group consisting of a refractory metal including titanium nitride, for example, TiN, CiSi, TaSiN, TiSiN, TaSi, TiSi, Ta, TaN, and an oxide of the platinum group metal.

Meanwhile, before forming the barrier layer 60, it is preferable that a metal silicide layer, for example, a titanium silicide layer, is formed on a substrate surface such that ohmic contact with a silicon substrate is formed to reduce contact resistance of the storage electrode. The titanium silicide layer can be formed by depositing titanium and then annealing it. At this time, instead of titanium, a material capable of forming a silicide with the silicon substrate, i.e., tungsten nitride (WN) or tungsten (W), can be also used.

Figure 4C is a sectional view showing a step of forming a platinum layer 65. Here, a platinum group metal to be used as a storage electrode, for example, platinum, is deposited on the barrier layer 60 through a sputtering method, to form a platinum layer 65.

It is preferable that the platinum layer 65 is formed in a thickness of approximately 1000 to 2000Å. Instead of the platinum, Ru, Ir, Rh, Os, and an oxide thereof can be used.

Before forming the platinum layer 65, an oxygen diffusion barrier layer (not shown) for preventing diffusion of oxygen passing through the platinum layer can be further formed between the barrier layer 60 and the platinum layer 65, where Ir, Ru, RuO2, IrO2 or a combined layer thereof can be used for the oxygen diffusion barrier layer.

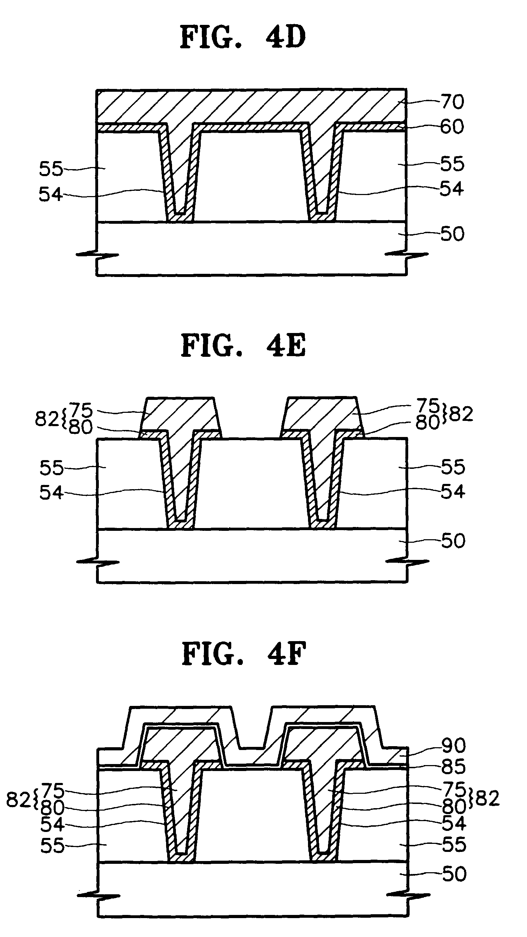

Figure 4D is a sectional view showing a step of reflowing the platinum layer 65 of Figure 4C. Here, the resultant structure where the platinum layer 65 is formed is introduced in a furnace, for example, a quartz tube, and then the platinum layer 65 is reflowed by heating, to fill the storage contact hole 54 and obtain a platinum layer 70 having a planarized surface.

The reflowing, preferably, is performed in N2 ambient at 650°C to 900°C, and for 5 minutes to 1 hour.

The platinum layer 70 planarized through the reflow and the semiconductor substrate 50 contact with each other through the barrier layer 60 on a bottom surface of the storage contact hole 54. While the conventional barrier layer is located between the conductive plug 16 of Figure 1B and the platinum layer pattern 24 of Figure 1B, i.e., above the storage contact hole 54, the barrier layer 60 according to the first embodiment of the present invention is located on the bottom surface of the storage contact hole 54.

Figure 4E is a sectional view showing the step of forming a storage electrode 82. Here, an insulating material, for example, an oxide, is deposited on the planarized platinum layer 70 in a thickness of 5000Å or more to form a mask layer used as an etching mask, and then patterned to form a mask pattern (not shown). Then, the planarized platinum layer 70 of Figure 4D and the barrier layer 60 of Figure 4D are sequentially etched using the mask pattern, to form the storage electrode 82 comprised of the platinum layer pattern 75 and the barrier layer pattern 80.

In the above-described storage electrode 82, a distance between the barrier layer pattern 80 formed on the bottom surface of the storage contact hole 54 and the surface of the platinum layer pattern 75, can be sufficiently maintained, which is equal to a distance obtained by adding a depth of a storage contact hole, a thickness of a platinum layer pattern and a thickness of a barrier layer pattern. That is, oxygen used during the process of forming a dielectric layer does not pass through the platinum layer pattern 75 and is prevented from combining with the barrier layer pattern 80 formed on the bottom surface of the storage contact hole.

As a result, oxygen can be prevented by the platinum layer from combining with the barrier layer, even though the platinum layer pattern 75 is not very thick or distant from the surface of the interlayer dielectric 55. Also, even though oxygen may infiltrate into the side of the barrier layer 80, the diffusion distance to the bottom surface of the storage contact 54 is relatively long, to thereby constrain formation of a titanium oxide layer due to the oxygen diffusion.

Figure 4F is a sectional view showing a step of forming a dielectric layer 85 and a plate electrode 90. Here, a dielectric material, for example, BST, is deposited on the substrate where the storage electrode 82 is formed, through a sputtering method or an MOCVD method, to form the dielectric layer 85, on which the plate electrode 90 is formed to complete a capacitor.

The dielectric material instead of the BST can be formed of one selected from the group consisting of Ta₂O₅, SiO₂, SiN₃, SrTiO₃, PZT, SrBi₂Ta₂O₉, (Pb,La)(Zr,Ti)O₃, Bi₄Ti₃O₁₂, and a combination thereof.

According to the first embodiment of the method for manufacturing a capacitor, a platinum layer is reflowed to fill a storage contact hole without forming a conductive plug. Accordingly, a diffusion distance of oxygen through a platinum layer pattern 75 and through the side of a barrier layer pattern 80 becomes long, such that the oxygen rarely reaches the barrier layer formed on the bottom surface of the storage contact hole. Therefore, oxidation of the barrier layer can be constrained, to thereby prevent contact failure of the storage electrode and generation of leakage current arising from the diffusion of oxygen or metal atoms. As a result, deterioration of electrical characteristics of a semiconductor device can be prevented. Also, since the storage electrode is not thick, patterning can be easily performed and a step difference from a portion around the capacitor can be reduced.

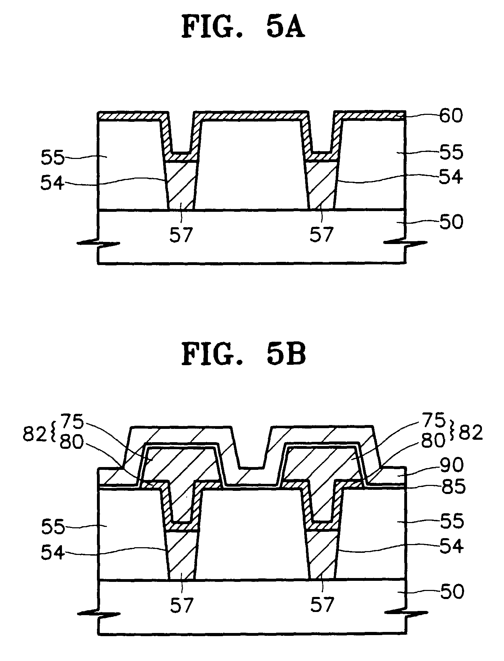

Figures 5A and 5B are sectional views for illustrating a second embodiment of the method for manufacturing a capacitor. The second embodiment is performed in the same manner as that of the first embodiment except for the step of forming a conductive plug 57 for filling a portion of the storage contact hole 54.

Figure 5A is a sectional view showing a step of forming the conductive plug 57 and the barrier layer 60. Here, the step of patterning an interlayer dielectric 55 to form the storage contact hole 54 (see Figure 4A) is performed in the same manner as that of the first embodiment. Then, a conductive material, for example, polysilicon, is deposited on the entire surface of the resultant structure where the storage contact hole is formed, to fill the storage contact hole 54 and a conductive layer having a predetermined thickness is formed on the interlayer dielectric 55.

The conductive layer is partially eliminated to form a conductive plug 57 for filling the storage contact hole to a portion of the total depth. Then, the barrier layer 60 is formed on the entire surface of the substrate, including where the conductive plug 57 is formed, in the same manner as the first embodiment.

The conductive plug 57 can be formed by eliminating a conductive layer on the interlayer dielectric through an etchback process, and then overetching the conductive layer filling the storage contact hole 54.

At this time, the conductive layer on the interlayer dielectric 55 is removed through a CMP process instead of the etchback process, and an etching selectivity of the interlayer dielectric with respect to the conductive layer is controlled by the removal rate of the CMP process to form the conductive plug 57 filling a portion of the storage contact hole 54.

Figure 5B is a sectional view showing a step of forming a capacitor formed of a storage electrode 82, a dielectric layer 85, and a plate electrode 90. Here, the storage electrode 82 formed of the platinum layer pattern 75 and the barrier layer pattern 80 in the same manner as that shown in Figures 4C through 4E, on the resultant structure having the conductive plug 57 are formed.

Then, the dielectric layer 85 and the plate electrode 90 are formed on the substrate having the storage electrode 82 to thereby complete a capacitor.

A filling depth of the storage contact hole by the conductive plug 57, i.e., a thickness of the conductive plug 57, is determined by an aspect ratio of the storage contact hole. When the aspect ratio of the storage contact hole is high, it is preferable that the conductive plug 57 is thick.

In the second embodiment, where a portion of the storage contact hole is filed with the conductive plug, it is preferable that the aspect ratio of the storage contact hole is high.

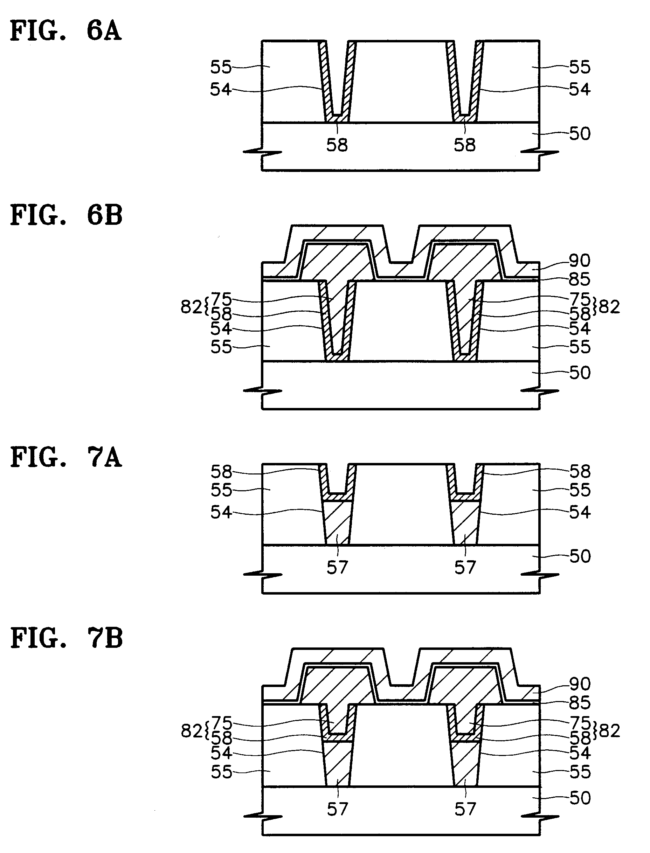

Figures 6A and 6B are sectional views for illustrating a third embodiment of the method for manufacturing a capacitor. The third embodiment is performed in the same manner as that in the first embodiment except for a step of removing the barrier layer formed on a region outside the storage contact hole 54 after forming the barrier layer 60 of Figure 4B.

Figure 6A is a sectional view showing a step of forming a barrier layer 58. Here, as shown in Figures 4A and 4B, the steps for forming the storage contact hole 54 and the barrier layer 60 are performed in the same manner as that of the first embodiment. Then, the barrier layer formed on the interlayer dielectric 55 is removed through the CMP process or the etchback process, to form the barrier layer pattern 58 in the storage contact hole 54.

Figure 6B is a sectional view showing a step of forming a storage electrode 82, a dielectric layer 85 and a plate electrode 90. The storage electrode 82 including a platinum layer pattern 75 and a barrier layer pattern 58 is formed on the resultant structure where the barrier layer pattern 58 is formed, through forming a platinum layer, reflowing and patterning it in the same manner as in Figures 4C through 4E.

Then, the dielectric layer 85 and the plate electrode 90 are formed on a substrate where the storage electrode 82 is formed, to complete a capacitor.

According to the third embodiment, the barrier layer pattern 58 is formed in the storage contact hole, so that the side of the barrier layer pattern during forming the dielectric layer 85 is not exposed. Therefore, oxidation of the barrier layer can be effectively constrained.

Figures 7A and 7B are sectional views for illustrating a fourth embodiment of the method for manufacturing a capacitor. The fourth embodiment is performed as the same manner as the third embodiment except for a process of forming a conductive plug 57 for filling a portion of the storage contact hole 54.

Referring to Figure 7A, the conductive plug 57 for filling a portion of the storage contact hole is formed like the second embodiment (see Figure 5A), and then a barrier layer is formed on the entire surface of the substrate where the conductive plug 57 is formed. The barrier layer formed on the interlayer dielectric 55 is removed through a CMP process or an etchback process as shown in the third embodiment (see Figure 6A) to form a barrier layer pattern 58 in the storage contact hole 54.

Figure 7B is a sectional view showing a step of forming a storage electrode 82, a dielectric layer 85 and a plate electrode 90. Here, a capacitor including the storage electrode 82, the dielectric layer 85 and the plate electrode 90 is completed in the same manner as the third embodiment (see Figure 6B).

In the fourth embodiment, since the storage contact hole 54 is partially filled with the conductive plug 57, as shown in the second embodiment, it is advantageous that the aspect ratio of the storage contact hole is high. Further, since the barrier layer pattern 58 is formed only in the storage contact hole, as shown in the third embodiment, the side surfaces of the barrier layer pattern 58 during forming the dielectric layer 85 are not exposed.

As described above, in the first through fourth embodiments, platinum is reflowed to form a platinum layer pattern for filling all or a portion of the storage contact hole, to thereby maintain a sufficient distance between the surface of platinum layer pattern and the barrier layer pattern, or between the surface of platinum layer pattern and the silicon substrate (or the conductive plug). Accordingly, even though the platinum layer is not thickly formed, oxygen is prevented from passing through the platinum layer and therefore cannot combine with the barrier layer. Also, even though oxygen is infiltrated into the side of the platinum layer, since the diffusion distance becomes long, formation of an oxide layer, i.e., a titanium oxide layer, due to oxygen diffusion, at an interface between the barrier layer pattern and the platinum layer pattern can be constrained.

Meanwhile, it is preferable that a material having an etch rate lower than that of platinum is used for the etching mask for forming a platinum layer pattern. However, since the platinum is hard and refractory, it is difficult to obtain a mask having an etch rate lower than that of the platinum. However, the platinum layer pattern can be formed using the platinum reflow without a mask, which will be in detail described with reference to the fifth and sixth embodiments.

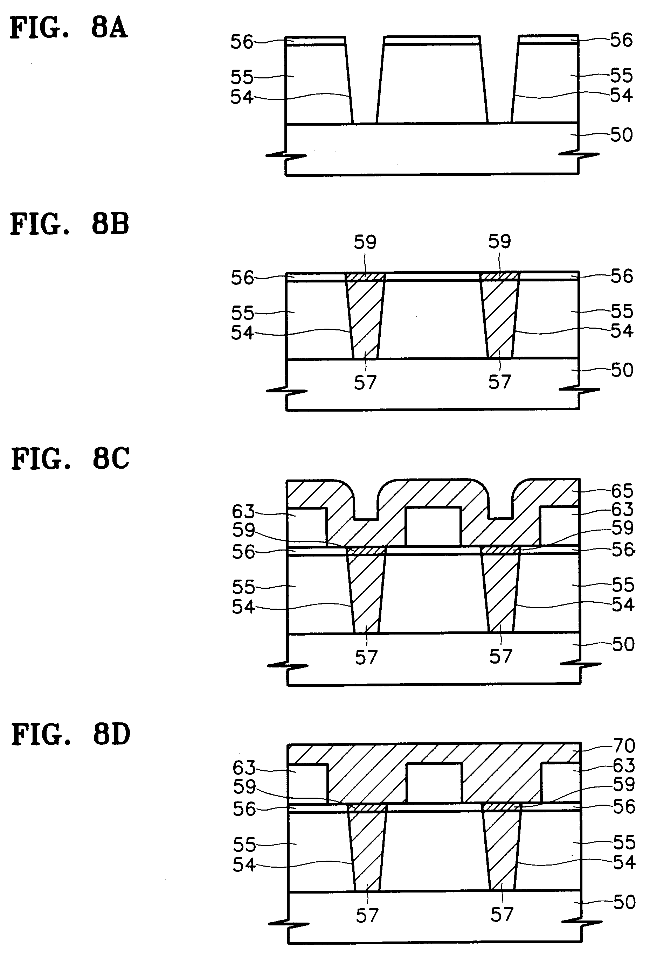

Figures 8A through 8F are sectional views for illustrating a fifth embodiment of a method for manufacturing a capacitor .

Figure 8A is a sectional view showing a step of forming a storage contact hole 54. Here, an insulating material such as undoped silicate glass (USG) and a nitride, is sequentially deposited on a semiconductor substrate 50, to form an interlayer dielectric 55 and an etching barrier layer 56, and then patterned to form a storage contact hole 54 exposing a predetermined portion of the substrate 50.

The etching barrier layer 56 is formed for preventing the interlayer dielectric 55 from being etched during patterning an etch stopper 63 of Figure 8C to be formed. Also, when the etch stopper is formed of a material having an etching selectivity higher than that of the interlayer dielectric 55, the etching barrier layer 56 may not be formed.

Figure 8B is a sectional view showing a step of forming a conductive plug 57 and a barrier layer pattern 59. Here, as described in the second embodiment (see Figure 5A), a conductive material such as polysilicon doped with impurities, is deposited on the entire surface of the substrate where the storage contact hole 54 is formed, to form a conductive layer for burying the storage contact hole 54, and then planarized through an etchback process or a CMP process, and further the conductive layer formed in the storage contact hole is partially overetched to form the conductive plug 57.
At this time, it is preferable that an overetched depth is equal to a thickness of the barrier layer.

Subsequently, the barrier metal such as a titanium nitride, is deposited on the entire surface of the substrate where the conductive plug 57 is formed, through a CVD method, and then etched until the etching barrier 56 is exposed, to form a barrier layer pattern 59 on the conductive plug 57. The refractory metal as described in the first embodiment, instead of titanium nitride can be used as the barrier metal, and the metal silicide layer for forming an ohmic contact layer can be formed between the barrier layer pattern 59 and the conductive plug 57.

Since the barrier layer pattern 59 is formed such that the upper end of the storage contact hole opened by overetching the conductive plug 57 is filled, the side thereof is not exposed.

Figure 8C is a sectional view showing a step of forming an etch stopper 63 and a platinum layer 65. Here, a material having a high wet etching selectivity to platinum, i.e., an oxide, is deposited on the etching barrier layer 56 and the barrier layer pattern 59, and then patterned, to form an etch stopper 63 having an opening portion where the storage electrode is to be formed. Then, a platinum group metal to be used as a storage electrode, i.e., platinum, is deposited on the substrate where the etch stopper 63 is formed, to form a platinum layer 65. It is preferable that the platinum layer 65 is formed in a thickness of 1000 ∼ 2000Å like the first embodiment (see Figure 4C), and it can be formed through a sputtering method.

Figure 8D is a sectional view showing a step of reflowing the platinum layer 65. Here, the platinum layer 65 is reflowed in the same manner as the first embodiment, to fill a portion opened by the etch stopper 63 and obtain a platinum layer 70 having a planarized surface.

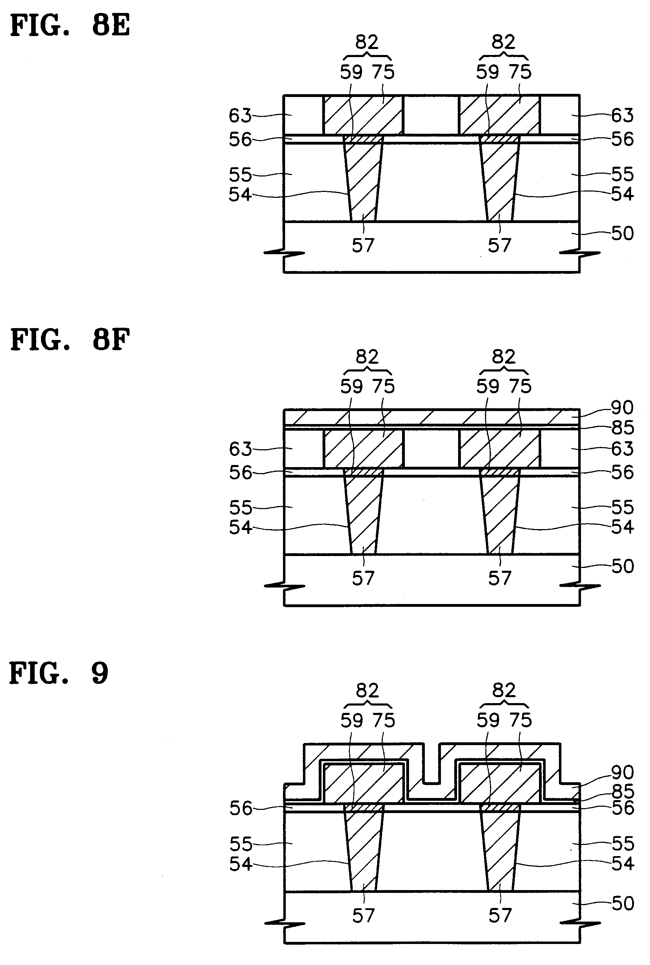

Figure 8E is a sectional view showing a step of forming a storage electrode 82. Here, the CMP process for the planarized platinum layer 70 is performed until the etch stopper 63 is exposed, to form a platinum layer pattern 75. Accordingly, the storage electrode 82 including the platinum layer pattern 75, and a barrier layer pattern 59 is formed.

As described above, the platinum layer pattern 75 formed through the CMP process does not require an etching mask, which is necessary for the conventional art.

Figure 8F is a sectional view showing a step of forming a dielectric layer 85 and a plate electrode 90. Here, a dielectric material such as BST or PZT, is deposited on the substrate where the storage electrode 82 is formed, through a sputtering method, to form the dielectric layer 85. Subsequently, the plate electrode 90 is formed on the dielectric layer 85 to complete a capacitor.

As can be seen in Figure 8F, since the dielectric layer 85 and the plate electrode 90 are formed in a state that the etch stopper 63 is not removed, only the upper surface of the storage electrode serves as a capacitor.

However, as shown in Figure 9, the etch stopper 63 can be removed using an etchant, i.e., buffered oxide etchant (BOE) before forming the dielectric layer 85. A dielectric material, i.e., BST or PZT, can be deposited on the entire surface of the resultant structure through a CVD method, to form the dielectric layer 85. Therefore, capacitance can be effectively increased due to increase in an effective area of the storage electrode.

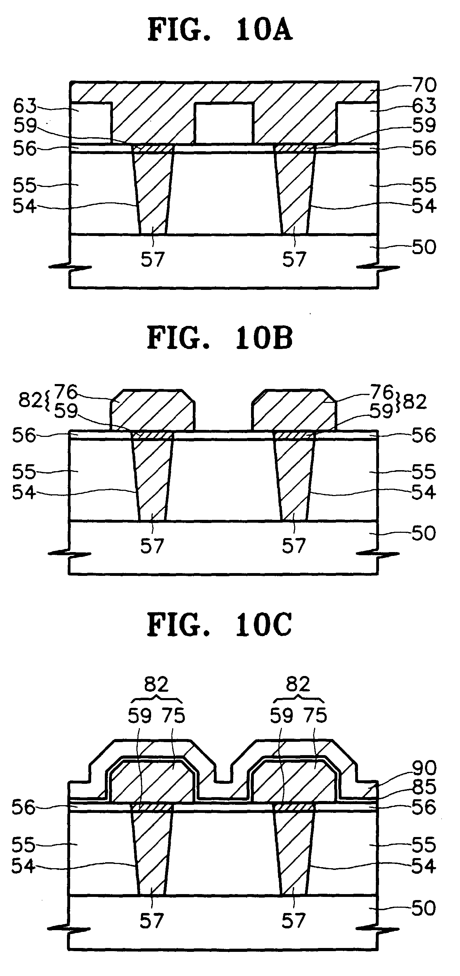

Figures 10A through 10C are sectional views for illustrating a sixth embodiment of a method for manufacturing a capacitor. The sixth embodiment is performed in the same manner as the fifth embodiment, except for etchback instead of the CMP with respect to the planarized platinum layer 70, to form a platinum layer pattern.

Figure 10A shows a step of forming a planarized platinum layer 70. Here, the planarized platinum layer 70 is obtained in the same manner as those shown in Figures 8A through 8D of the fifth embodiment.

Figure 10B is a sectional view showing a step of forming a platinum layer pattern 76. Here, unlike the fifth embodiment, where the platinum layer pattern 75 of Figure 8E is formed through the CMP method, entire surfaces of the planarized platinum layer pattern 70 and an etch stopper 63 are blanket- etched back.

At this time, since the etch rate of the etch stopper 63 formed of oxide is faster than that of the planarized platinum layer 70, the etchback is performed until the etching barrier layer 56 is exposed, to thereby form the platinum layer pattern 76 having a cut upper edge as shown in Figure 10A.

Accordingly, unlike the fifth embodiment in which after the CMP process, the etch stopper 63 is removed and the platinum layer pattern 75 of Figure 9 is formed, formation of the platinum layer pattern 76 and removal of the etch stopper 63 are carried out through the blanket etchback, which leads to simplification of the manufacturing process.

Figure 10C is a sectional view showing a step of forming a dielectric layer 85 and a plate electrode 90. Here, the dielectric layer 85 and the plate electrode 90 are formed on the storage electrode 82 including the barrier layer pattern 59 and the platinum layer pattern 76, to complete a capacitor. As described above, according to the fifth and sixth embodiments, the etch stopper 63 having an opening portion is formed and the platinum is deposited and reflowed, to fill the opening portion of the etch stopper, and further the platinum layer pattern is formed by performing the CMP or the etchback process. Accordingly, the etching mask for forming the platinum layer pattern 75 is not necessary, and further the platinum layer pattern 75 can be easily formed.

Two or more of the first through sixth embodiments can be combined, as will be described with reference to the seventh through fourteenth embodiments.

Figures 11A through 11E are sectional views for illustrating a seventh embodiment of a method for manufacturing a capacitor. In the seventh embodiment, which can be obtained by combining the first embodiment (see Figures 4A through 4F) with the fifth embodiment (see Figures 8A through 8F), the barrier layer is formed in the storage contact hole (refer to the first embodiment), and the platinum layer pattern is formed without an etching mask (refer to the fifth embodiment).

Figure 11A is a sectional view showing a step of forming a barrier layer 60 and an etch stopper 63. Here, as shown in Figures 4A and 4B of the first embodiment, the interlayer dielectric 55, the storage contact hole 54 and the barrier layer 60 are formed on the semiconductor substrate 50, and then as shown in Figure 8C of the fifth embodiment, the etch stopper 63 in which a portion where the storage electrode is to be formed is open, is formed.

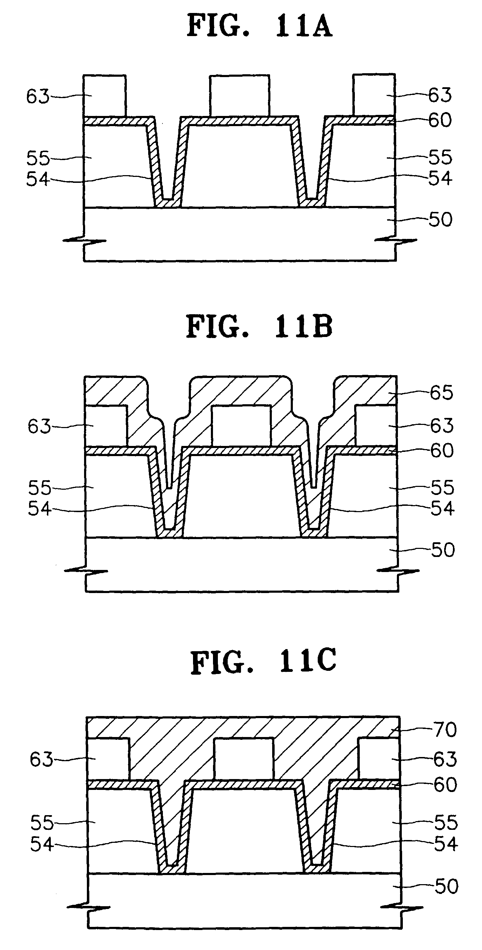

Figure 11B is a sectional view showing a step of forming a platinum layer 65. Here, the platinum layer 65 is formed on the entire surface of the substrate where the etch stopper 63 is formed.

Figure 11C is a sectional view showing a step of forming a planarized platinum layer 70. Here, the platinum layer 65 is reflowed like the first embodiment, to bury a portion opened by the storage contact hole 54 and the etch stopper 63.

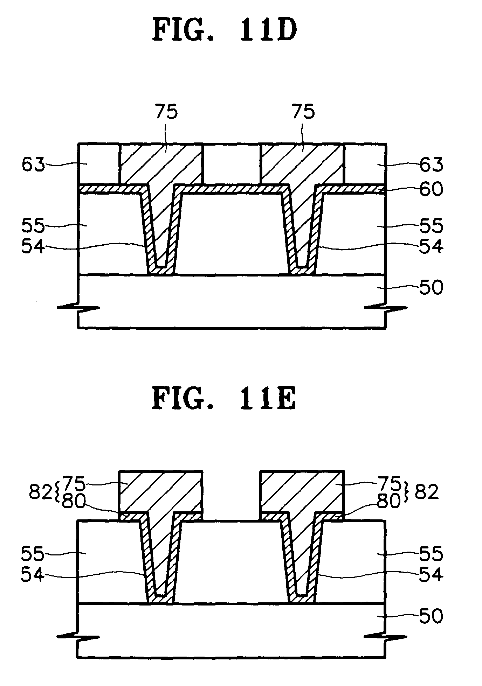

Figure 11D is a sectional view showing a step of forming a platinum layer pattern 75. Here, a planarization process, for example, a CMP, is performed until the etch stopper 63 is exposed, to form the platinum layer pattern 75.

Figure 11E is a sectional view showing a step of forming a storage electrode 82. Here, the etch stopper 63 of Figure 11D is removed, and then the barrier layer 60 of Figure 11D is etched using the platinum layer pattern 75 as an etching mask to form a barrier layer pattern 80. Therefore, the storage electrode 82 including the platinum layer pattern 75 and the barrier layer pattern 80 is formed.

Then, a dielectric layer and a plate electrode are formed in the same manner as that of the first embodiment.

The storage electrode in the seventh embodiment has the same structure as that of the first embodiment (see Figure 4E). Accordingly, like in the first embodiment, during forming the dielectric layer, a distance of oxygen diffused from the surface of the platinum layer pattern 75 and from the side of the barrier layer pattern 80 becomes long, and thus contact failure of the storage electrode does not occur. Also, like in the fifth embodiment, the platinum layer pattern 75 can be formed without an etching mask.

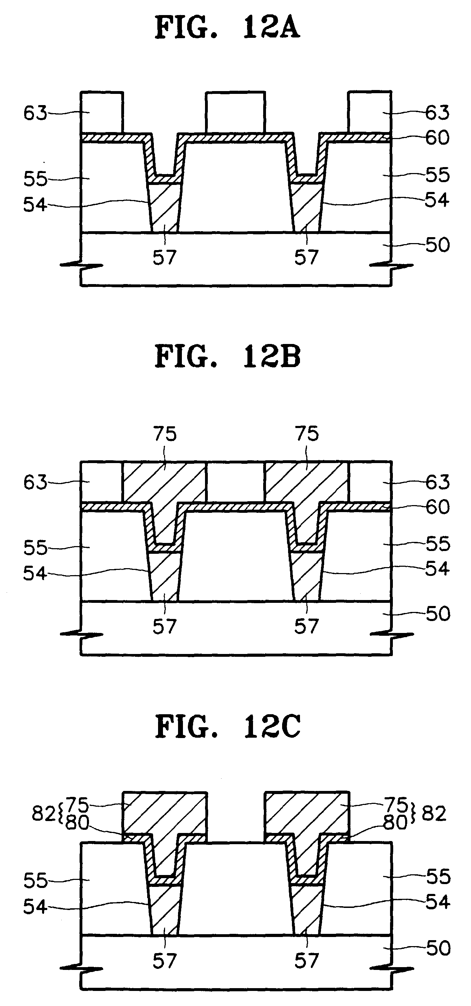

Figures 12A through 12C are sectional views for illustrating an eighth embodiment of a method for manufacturing a capacitor. The eighth embodiment, which is obtained by combining the second embodiment (see Figures 5A and 5B) with the fifth embodiment (see Figures 8A through 8F), is performed in the same manner as that of the seventh embodiment, except a process of forming a conductive plug 57 for filling a portion of the storage contact hole 54.

That is, according to the eighth embodiment, as shown in Figure 12A, the conductive plug 57 for filling a portion of the storage contact hole 54 and the barrier layer 60 are formed in the same manner as that of the second embodiment, and then an etch stopper 63 is formed with having an opening portion where the storage electrode is to be formed. Subsequently, as the same manner as that of the seventh embodiment, a platinum layer pattern 75 is formed as shown in Figures 12B and 12C and the etch stopper 63 is removed, and then a storage electrode 82 including the platinum layer pattern 75 and the barrier layer pattern 80 is formed.

The storage electrode 82 of the eighth embodiment has the same structure of the storage electrode (see Figure 5B) of the second embodiment. Therefore, it is advantageous that the aspect ratio of the storage contact hole is high, like the second embodiment, and the platinum layer pattern can be formed without an etching mask to simplify a manufacturing process, compared with the second embodiment.

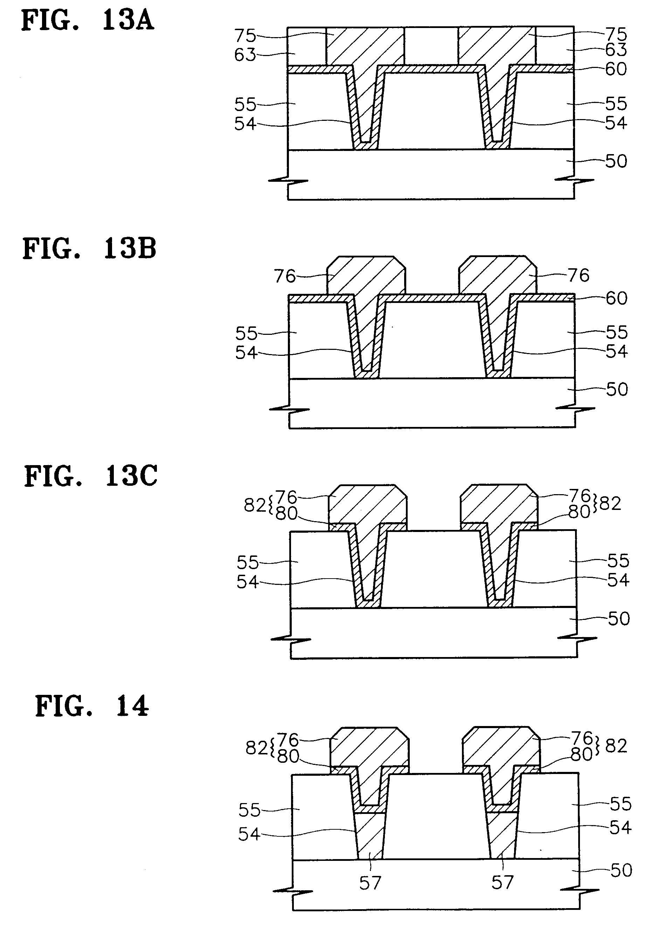

Figures 13A through 13C are sectional views for illustrating a ninth embodiment of a method for manufacturing a capacitor. The ninth embodiment, which is obtained by combining the first embodiment (see Figures 4A through 4F) with the sixth embodiment (see Figures 10A through 10C), is performed in the same manner as that of the seventh embodiment except for blanket-etching back the planarized platinum layer (70 of Figures 11C and 13A) during forming a platinum layer pattern.

As shown in Figure 13A, the steps for forming the planarized platinum layer 70 are performed in the same manner as shown in the seventh embodiment, and then the planarized platinum layer 70 and the etch stopper 63 are blanket-etched back as in the sixth embodiment (see Figure 10B), to form a platinum layer pattern 76 having cut upper edges (Figure 13B). Subsequently, as shown in Figure 13C, the barrier layer 60 (see Figure 13B) is etched using the platinum layer pattern 76 as a mask, to form a storage electrode 82 including the platinum layer pattern 76 and the barrier layer pattern 80.

Figure 14 is a sectional view for illustrating a tenth embodiment of the method for manufacturing a capacitor, which is obtained by combining the second embodiment (see Figures 5A and 5B) with the sixth embodiment (see Figures 10A through 10C), and is the same as the ninth embodiment except for forming a conductive plug 57 filling a portion of the storage contact hole 54.

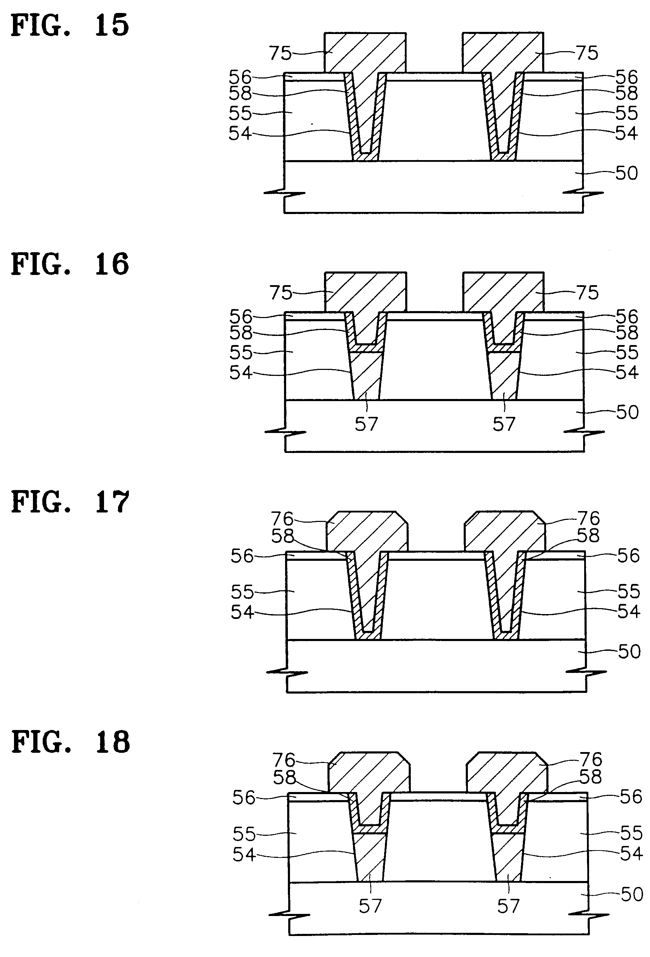

Figure 15 is a sectional view for illustrating an eleventh embodiment of the method for manufacturing a capacitor which is obtained by combining the third embodiment (see Figures 6A and 6B) and the fifth embodiment (see Figures 8A through 8F), and is the same as the seventh embodiment except for forming the barrier layer pattern 58 only in the storage contact hole 54.

Referring to Figure 15, the barrier layer pattern 58 in the storage contact hole is formed, and an etch stopper 63 of Figure 11D and a platinum layer pattern 75 are formed on the resultant structure where the barrier layer pattern 58 is formed and the etch stopper is removed in the same manner as that of the seventh embodiment (see Figures 11A through 11D). At this time, it is preferable that an etching barrier layer 56 for preventing the interlayer dielectric 55 from being etched is formed, however, it need not be formed in the case that the etch stopper is formed of a material having a high etching selectivity with respect to the interlayer dielectric 55.

Figure 16 is a sectional view for illustrating a twelfth embodiment of the method for manufacturing a capacitor, which is obtained by combining the fourth embodiment (see Figures 7A and 7B) with the fifth embodiment (see Figures 8a through 8F), and is the same as the eleventh embodiment except for forming the conductive plug 57 filling a portion of the storage contact hole 54, as shown in Figure 16.

Figure 17 is a sectional view for illustrating a thirteenth embodiment of a manufacturing method, which is obtained by combining the third embodiment (see Figures 6A and 6B) with the sixth embodiment (see FIGS 10A. through 10C), and is the same as the eleventh embodiment except for forming the platinum layer pattern 76 having slantingly cut edges through the etchback.

Figure 18 is a sectional view for illustrating a fourteenth embodiment which is obtained by combining the fourth embodiment (see Figures 7A and 7B) with the sixth embodiment(see Figures 10A through 10C), and is the same as the thirteenth embodiment except for forming a conductive plug 57 filling a portion of the storage contact hole 54.

The method described herein for forming the platinum group metal layer using reflow has many advantages in forming a storage electrode of a capacitor, as follows.

First, deterioration can be inhibited of the electrical characteristics of a semiconductor device due to oxygen diffusion through the upper surface of the platinum layer pattern and the side of the exposed barrier layer during formation of a dielectric layer.

The platinum layer pattern and the barrier layer pattern contact with a substrate or a conductive plug in the storage contact hole. That is, a distance between the surface of the platinum layer pattern and the barrier layer pattern is maintained such that oxygen infiltrating through the surface of the platinum layer pattern and the side of the barrier layer pattern cannot reach the barrier layer which contacts with the substrate or the conductive plug. Accordingly, since the distance of oxygen diffusion is long, an oxide layer, for example, a titanium oxide layer is rarely formed at an interface between the barrier layer pattern and the platinum layer pattern.

Second, since an etching mask is unnecessary, the metal pattern of the platinum group can be more easily formed than in the conventional art.

It should be understood that the invention is not limited to the illustrated embodiment and that many changes and modifications can be made within the scope of the invention by a person skilled in the art.

The reader's attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A method for forming a platinum group metal layer comprising the steps of:
a) forming a material layer (42) on a semiconductor substrate (10);
b) etching a predetermined portion of the material layer to form an opening (43);
characterised by:
c) depositing a platinum group metal (44) on the entire surface of the substrate where the opening is formed; and
d) reflowing the platinum group metal (44) to fill the opening (43).

2. The method of claim 1, wherein the material layer (42) is formed of an undoped silicate glass.

3. The method of claim 1, wherein the platinum group metal (44) is one selected from the group consisting of Pt, Ru, Ir, Rh, Os, RuO₂, and IrO₂.

4. The method of claim 1, wherein the platinum group metal (44) is formed having a thickness in the region of 1000 to 2000Å.

5. The method of claim 1, wherein said reflowing is performed in an N₂ atmosphere, in the region of 650 to 900°C, and for in the region of 5 minutes to 1 hour.

6. A method for manufacturing a capacitor comprising the steps of:
a) forming an interlayer dielectric (55) on a semiconductor substrate (50);
b) patterning the interlayer dielectric to form a storage contact hole (54) for exposing a predetermined portion of the substrate (50);
c) depositing a barrier metal on the entire surface of the substrate where a storage contact hole (54) is formed to form a barrier layer (60) on the interlayer dielectric (55) and the storage contact hole surface;
d) depositing a platinum group metal on the barrier layer (60) to form a metal layer (65);
e) reflowing the metal layer to form a reflowed metal layer (70) having a predetermined thickness for filling the storage contact hole (54), on the interlayer dielectric;
f) patterning the reflowed metal layer (70) and the barrier layer (60) to form a storage electrode pattern (82) including a metal layer pattern (75) and a barrier layer pattern (80);
g) forming a dielectric layer (85) on the metal layer pattern; and
h) forming a plate electrode (90) on the dielectric layer.

7. The method of claim 6, further comprising the step of:
forming a metal silicide layer for reducing contact resistance with the substrate (50) on the bottom surface of the storage contact hole (54) before said step c).

8. The method of claim 6, further comprising the step of:
forming an oxygen diffusion barrier layer formed of one selected from the group consisting of Ir, Ru, RuO₂ and IrO₂, between the barrier layer (60) and the metal layer (70), before said step d).

9. The method of claim 6, further comprising the step of:
forming a conductive plug (57) for filling a portion of the storage contact hole (54), before said step c) of forming the barrier layer (60).

10. The method of claim 9, wherein said step of forming the conductive plug (57) comprises the sub-steps of:
forming a conductive layer having a predetermined thickness for filling the storage contact hole (54), on the interlayer dielectric (55);
removing the conductive layer on the interlayer dielectric by etching back; and
removing a portion of the conductive layer filling the storage contact hole by overetching.

11. The method of claim 9, wherein said step of forming the conductive plug (57) comprises the sub-steps of:
forming a conductive layer having a predetermined thickness on the interlayer dielectric (55), to fill the storage contact hole (54);
removing the conductive layer on the interlayer dielectric using chemical-mechanical polishing; and
removing a portion of the conductive layer in the storage contact hole (54) using the chemical-mechanical polishing in which an etching selectivity between the conductive layer and the interlayer dielectric is controlled.

12. The method of any of claims 6 to 11, wherein the barrier layer (60) formed on the interlayer dielectric is removed to form the barrier layer (58) only in the storage contact hole (54), and wherein only the metal layer (70) is patterned during the step of forming the storage electrode pattern (82).

13. The method of any of claims 6 to 12, wherein the barrier layer (60) is formed of one selected from the group consisting of TiN, CoSi, TaSiN, TiSiN, TaSi, TiSi, Ta and TaN.

14. A method for manufacturing a capacitor comprising the steps of:
a) forming an interlayer dielectric (55) on a semiconductor substrate (50);
b) patterning the interlayer dielectric (55) to form a storage contact hole (54) for exposing a predetermined portion of the substrate (50);
c) forming a conductive plug (57) for filling the storage contact hole (54) and overetching the conductive plug to form an opening at the upper end of the storage contact hole (54) in a predetermined thickness;
d) filling the opening at the upper end of the etched storage contact hole to form a barrier layer pattern (59) having unexposable sides;
e) forming an etch stopper (63) having an opening portion where the storage electrode is to be formed, on the interlayer dielectric (55);
f) depositing a platinum group metal to form a metal layer (65) on the entire surface of the substrate where the etch stopper is formed;
g) reflowing the metal layer to form a reflowed metal layer (70) having a predetermined thickness for filling the opening portion opened by the etch stopper (63), on the etch stopper;
h) removing the reflowed metal layer (70) until the etch stopper (63) is exposed, to form a metal layer pattern (75);
i) forming a dielectric layer (85) on the metal layer pattern; and
j) forming a plate electrode (90) on the dielectric layer.

15. The method of claim 14, wherein the metal layer pattern (75) is formed by chemical-mechanical polishing the reflowed metal layer (70) until the etch stopper (63) is exposed.

16. The method of claim 14 or 15, further comprising the step of removing the etch stopper (63), to thereby form the dielectric layer (85) on the upper and the side surfaces of the metal layer pattern (75), after said step i).

17. The method of claim 14, further comprising the step of:
forming an etching barrier layer (56) on the interlayer dielectric after said step a), and wherein the storage contact hole (54) is formed by sequentially etching the etching barrier layer (56) and the interlayer dielectric.

18. The method of claim 17, wherein the metal layer is formed by blanket etching back the reflowed metal layer (70) and the etch stopper (63) until the etching barrier layer (56) is exposed.

19. The method of claim 17 or 18, wherein the etch stopper (63) is formed of an oxide and the etching barrier layer (56) is formed of a nitride.

20. A method for manufacturing a capacitor comprising the steps of:
a) forming an interlayer dielectric (55) on a semiconductor substrate (50);
b) patterning the interlayer dielectric (55) to form a storage contact hole (54) for exposing a predetermined portion of the substrate (50);
c) depositing a barrier metal on the entire surface of the substrate where the storage contact hole is formed to form a barrier layer (60) on the interlayer dielectric and on the surface of the storage contact hole;
d) forming an etch stopper (63) having an opening portion where a storage electrode is to be formed, on the barrier layer;
e) depositing a platinum group metal on the entire surface of the substrate where the etch stopper is formed, to form a metal layer (65);
f) reflowing the metal layer to form a reflowed metal layer (70) having a predetermined thickness for filling the opening portion opened by the etch stopper and the storage contact hole, on the etch stopper;
g) removing the reflowed metal layer (70) until the etch stopper (63) is exposed, to form a metal layer pattern (75);
h) removing the etch stopper (63);
i) patterning the barrier layer (60)using the metal layer pattern as an etching mask, to form a barrier layer pattern (80) only under the metal layer pattern (75);
j) forming a dielectric layer on the metal layer pattern; and
k) forming a plate electrode on the dielectric layer.

21. The method of claim 20, wherein the metal layer pattern (75) is formed by chemical mechanical polishing the reflowed metal layer (70) until the etch stopper is exposed.

22. The method of claim 20, wherein the metal layer pattern (75) is formed by etching back the reflowed metal layer (70) and the etch stopper until the barrier layer is exposed.

23. The method of claim 20, 21 or 22, further comprising the step of:
forming a conductive plug (57) for filling a portion of the storage contact hole, before the barrier layer is formed.

24. A method for manufacturing a capacitor comprising the steps of:
a) forming an interlayer dielectric (55) on a semiconductor substrate (50);
b) patterning the interlayer dielectric (55) to form a storage contact hole (54) for exposing a predetermined portion of the substrate;
c) depositing a barrier layer on the entire surface of a substrate where the storage contact hole is formed, to form a barrier layer on the interlayer dielectric and the surface of the storage contact hole;
d) removing the barrier layer formed on the interlayer dielectric, to form a barrier layer pattern (58) only on the surface of the storage contact hole;
e) forming an etch stopper having an opening portion where a storage electrode is to be formed, on the interlayer dielectric;
f) depositing a platinum group metal to form a metal layer on the entire surface of the substrate where the etch stopper is formed;
g) reflowing the metal layer to form a reflowed metal layer having a predetermined thickness for filling an opening portion opened by the etch stopper and filling the storage contact hole, on the etch stopper;
h) removing the reflowed metal layer until the etch stopper is exposed to form a metal layer pattern (75);
i) forming a dielectric layer on the metal layer pattern; and
j) forming a plate electrode on the dielectric layer.

25. The method of claim 24, further comprising the step of:
forming an etching barrier layer (56) on the interlayer dielectric after said step a), and wherein the storage contact hole is formed by sequentially etching the etching barrier layer and the interlayer dielectric.

26. The method of claim 24 or 25, further comprising the step of:
removing the etch stopper (63) after said step h), to form the dielectric layer on the upper and the side surfaces of the metal layer pattern.

27. The method of claims 24, 25 or 26, wherein the metal layer pattern is formed by chemical-mechanical polishing the reflowed metal layer until the etch stopper is exposed.

28. The method of claims 24, 25 or 26, wherein the metal layer pattern is formed by blanket etching back the reflowed metal layer and the etch stopper until the etching barrier layer is exposed.

29. The method of claim 27 or 28, further comprising the step of:
forming a conductive plug (57) for filling a portion of the storage contact hole before said step c).

30. The method of any of claims 6 to 29, wherein the interlayer dielectric is formed of an oxide undoped with impurities.

31. The method of any of claims 6 to 30, wherein the metal layer is formed of one selected from the group consisting of Pt, Ru, Ir, Rh, Os, RuO₂ and IrO₂.

32. The method of claim 31, wherein the metal layer is formed of platinum Pt.

33. The method of any of claims 6 to 32, wherein the dielectric layer is formed of one selected from the group consisting of Ba(Sr,Ti)O₃, Pb(Zr,Ti)O₃, Ta₂O₅, SiO₂, SiN₃, SrTiO₃, PZT, SrBi₂Ta₂O₉, (Pb, La)(Zr, Ti)O₃, and Bi₄Ti₃O₁₂.

34. The method of any of claims 6 to 33, wherein the metal layer is formed having a thickness in the region of 1000 to 2000Å.

35. The method of any of claims 6 to 34, wherein said relowing is performed by heating at more than 650°C.

36. The method of any of claims 6 to 34, wherein said reflowing is performed in an N₂ atmosphere, in the region of 650 to 900°C, and for in the region of 5 minutes to 1 hour.
